# FASCICULE DE BREVET EUROPEEN

(11) **EP 1 302 096 B1**
(45) Date de publication et mention de la délivrance du brevet: **15.02.2006**
(21) Numéro de dépôt: 01928043.7
(22) Date de dépôt: 24.04.2001
(51) Int. Cl.: H05K 7/14, B60R 11/02

(54) **EQUIPEMENT A POIGNEE PIVOTANTE, NOTAMMENT POUR ETRE SUSPENDU DANS UNE CONSOLE D'AERONEF**
VORRICHTUNG MIT BEWEGLICHEM HANDGRIFF, INSBESONDERE ZUR AUFHÄNGUNG IN EINER KONSOLE EINES FLUGZEUGS
EQUIPMENT WITH PIVOTING HANDLE, IN PARTICULAR TO BE SUSPENDED IN AN AIRCRAFT CONSOLE

(30) Priorité: 09.05.2000 FR 0005862
(43) Date de publication de la demande: 16.04.2003
(73) Titulaire: Thales, 75008 Paris (FR)
(72) Inventeur: LABROUSSE, Gilles, Thomson-CSF Propriété Intell., F-94117 Arcueil Cedex (FR); TANTET, Alain, Thomson-CSF Propriété Intell., F-94117 Arcueil Cedex (FR)
(74) Mandataire: Lucas, Laurent Jacques
(86) Numéro de dépôt international: PCT/FR2001/001249
(87) Numéro de publication internationale: WO 2001/087030

(56) Documents cités:
- EP-A- 0 524 040
- DE-A- 3 941 030
- GB-A- 781 145
- US-A- 4 991 818
- US-A- 5 208 735

## Description

L'invention concerne un équipement à poignée pivotante, et notamment un équipement suspendu pour console d'aéronef. L'équipement doit pouvoir être mis en place dans un système et retiré de ce système, par exemple pour être révisé ou remplacé. Dans le cas préférentiel d'une console d'aéronef, l'équipement installé sur la console est avantageusement monté verrouillé suspendu par sa face avant sur la console et possède une poignée pivotante afin de simplifier son installation.

Une fois l'équipement installé dans un système, la poignée pivotante est rabattue. Lorsqu'un opérateur veut extraire cet équipement du système, et particulièrement d'un système ayant des contraintes importantes de faible encombrement, il trouve souvent la poignée coincée, et l'extraction est alors souvent réalisée en endommageant l'équipement et les équipements voisins éventuellement présents dans le même système, par l'utilisation d'outils du type levier pour pouvoir accéder à la poignée. Les causes du coinçage de la poignée peuvent être multiples, par exemple une forte contrainte d'encombrement obligeant à emboîter au plus juste dans un même système différents équipements de la manière la plus compacte possible, ou bien un désalignement entraînant un coinçage de la poignée lors de sa mise en place dans le système.

Le document DE 3941030 décrit des moyens élastiques pour éjecter une poignée pivotante.

L'invention propose un équipement structuré de manière à ce que la poignée soit automatiquement rendue accessible lors de l'extraction de l'équipement. Pour cela, la poignée est rendue accessible par éjection automatique, après déverrouillage par exemple de l'équipement et de la poignée pivotante associée, facilitant ainsi l'extraction proprement dite de l'équipement. L'assemblage et la fabrication des moyens permettant cette éjection automatique de la poignée sont simples et peu coûteux.

Selon l'invention, il est prévu un équipement tel que défini dans la revendication 1.

L'invention sera mieux comprise et d'autres particularités et avantages apparaîtront à l'aide de la description ci-après et des dessins joints, donnés à titre d'exemples, où :
- la figure 1 représente schématiquement une vue d'ensemble en perspective d'un mode de réalisation préférentiel d'une partie de l'équipement selon l'invention ;
- la figure 2 représente schématiquement une vue de profil d'un détail de la figure 1 ;
- la figure 3 représente schématiquement une vue en perspective d'un mode de réalisation préférentiel d'une autre partie de l'équipement selon l'invention ;
- la figure 4 représente schématiquement une vue en coupe d'un détail de la figure 3.

L'équipement selon l'invention comporte un support. Une poignée pivotante est assemblée avec le support par au moins un axe de rotation. La poignée pivotante peut reposer sur au moins une surface du support lorsque la poignée est rabattue, ce qui rend l'ensemble de l'équipement plus compact. La poignée peut en fait reposer sur tout ou partie d'une ou plusieurs surfaces du support. La poignée comporte au moins une surface d'appui. L'équipement comporte au moins un patin en matériau élastique qui est situé entre la surface d'appui et le support, de sorte que lorsque la poignée est rabattue après installation de l'équipement, c'est-à-dire lorsque la poignée repose sur la surface du support, le patin en matériau élastique soit comprimé entre la surface d'appui et le support. Dans toute la suite du texte, sauf mention contraire, on parlera indifféremment de patin ou de patin en matériau élastique. Ainsi, lors de l'extraction, après le déverrouillage, le patin comprimé a tendance à reprendre sa forme initiale, c'est-à-dire non comprimé, en écartant du support la surface d'appui, c'est-à-dire en les repoussant l'un de l'autre, éjectant alors la poignée qui était rabattue sur la surface du support et la rendant ainsi accessible à l'opérateur qui peut alors extraire facilement l'équipement. L'élasticité du patin en matériau élastique est déterminée de manière à permettre à la fois à la poignée d'être rabattue lors de l'installation et à la même poignée d'être éjectée lors de l'extraction.

L'équipement selon l'invention est particulièrement intéressant dans les systèmes ayant une contrainte importante de faible encombrement, puisqu'il permet à la fois une compacité élevée de l'équipement lors de son installation, et un décoinçage de la poignée par éjection facilitant l'extraction de l'équipement et évitant la détérioration de ce même équipement ou des équipements voisins éventuellement présents dans le système. Dans le cas préférentiel d'une console pour aéronef, en permettant une bonne compacité de l'équipement sans présence d'excroissance notable sur ce même équipement, l'invention d'une part permet à la main que le pilote fait glisser sur la console de ne pas rencontrer d'obstacle et d'autre part ne gêne pas la visibilité du pilote sur les touches de l'équipement suspendu de la console, même sur les touches voisines de la poignée.

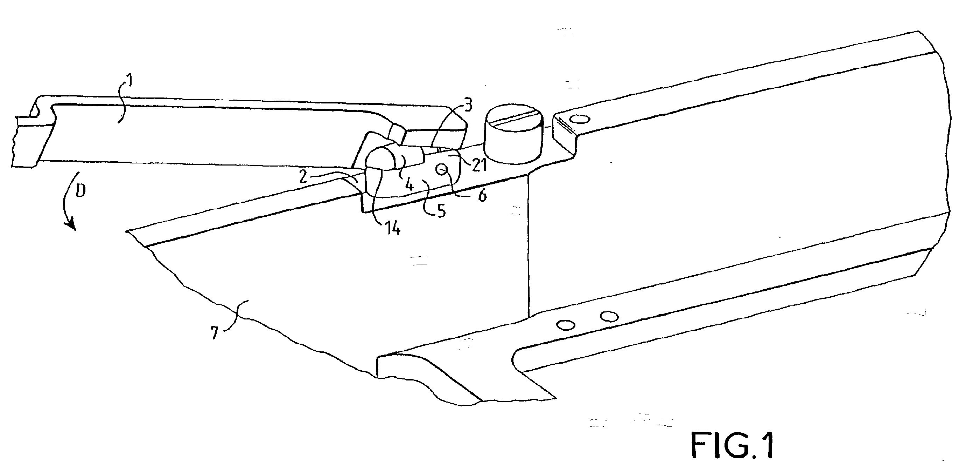

La figure 1 représente schématiquement une vue d'ensemble en perspective d'un mode de réalisation préférentiel d'une partie de l'équipement selon l'invention. Un support 7 de l'équipement comporte une surface 2 du support 7 sur laquelle vient reposer une poignée 1 lorsque la poignée 1 est rabattue contre l'équipement après installation de celui-ci. Le support 7 comporte préférentiellement un bossage 5 lequel porte un axe 6 de rotation. La poignée 1 est assemblée avec le support 7 par l'intermédiaire de l'axe 6 de rotation. La flèche D indique le sens de rotation de la poignée 1 lorsque la poignée 1 est rabattue contre l'équipement, c'est-à-dire lorsque la poignée 1 vient reposer sur la surface 2 du support 7. La poignée 1 comporte une surface 3 d'appui qui vient comprimer un patin en matériau élastique 4 contre le support 7, c'est-à-dire plus précisément ici contre le bossage 5. Le bossage 5 comporte avantageusement une marche 21, le patin en matériau élastique 4 étant fixé au bas de la marche 21, c'est-à-dire sur une surface 14, tandis que l'axe 6 de rotation est inclus dans la marche 21. Lors de l'extraction, le patin en matériau élastique 4 repousse la surface 3 d'appui qui s'écarte de la surface 14 sur laquelle est fixée le patin en matériau élastique 4. La poignée 1 est alors éjectée, c'est-à-dire repoussée de la surface 2 du support 7 sur laquelle elle reposait de sorte à être rendue accessible à un éventuel opérateur, par une rotation autour de l'axe 6 de rotation dans le sens inverse de la flèche D. La poignée 1 reste toutefois solidaire du support 7 par l'intermédiaire de l'axe 6 de rotation.

Le patin en matériau élastique 4 est de préférence fixé sur le support 7, mais il peut également être fixé sur la surface 3 d'appui de la poignée 1. Le support 7 comporte de préférence un bossage 5 qui comporte l'axe 6 de rotation et le patin en matériau élastique 4, mais ceux-ci peuvent être intégrés dans le support 7 ou même disparaître dans le support 7 de sorte que celui-ci ne présente plus de proéminence.

Le patin en matériau élastique 4 est situé suffisamment près de l'axe 6 de rotation pour permettre l'éjection de la poignée 1 lorsque la poignée 1 repose sur la surface 2 du support 7 et lorsque la poignée 1 est déverrouillée, c'est-à-dire lorsque la poignée 1 repose sur la surface 2 du support 7 tout en étant déverrouillée. Le patin 4 est alors idéalement placé le plus près possible de l'axe 6 de rotation. Plus le patin en matériau élastique 4 est placé près de l'axe 6 de rotation, plus la force nécessaire pour éjecter la poignée 1 avec une amplitude suffisamment grande pour la rendre accessible lors de l'extraction est faible. La contrainte concernant l'élasticité du patin en matériau élastique 4 est alors relâchée.

La poignée 1 comporte un trou de passage traversé par l'axe 6 de rotation. Le trou de passage est avantageusement oblong. La grande dimension du trou oblong est préférentiellement parallèle à la surface 2 du support 7, lorsque la poignée 1 repose sur la surface 2 du support 7. Cette grande dimension est dans le cas de la figure 1 également parallèle à la surface 3 d'appui. Ainsi la poignée 1 se rabat plus facilement lors de l'installation et est aussi éjectée plus facilement lors de l'extraction. Le risque de coinçage de la poignée 1 dans le système est ainsi diminué. Dans le cas préférentiel d'une console d'aéronef, le risque de coinçage est notamment situé au niveau du rail de verrouillage de la console.

La poignée 1 a de préférence une forme en U, les branches du U étant reliées à la barre centrale du U par des angles sensiblement droits. La poignée 1 vient se placer autour du centre de l'équipement lorsque la poignée 1 est rabattue sur la surface 2 du support 7. L'équipement comporte avantageusement un patin en matériau élastique 4 au niveau de chacune des branches du U, un axe 6 de rotation étant situé au niveau de chaque extrémité du U. L'équipement est par exemple sensiblement rectangulaire. Dans toute la suite du texte, on ne décrira, sauf mention contraire, que ce qui se passe au niveau d'une des branches du U et on ne considéra donc que le patin en matériau élastique 4 appartenant à ladite branche du U.

La surface 3 d'appui est de préférence sensiblement plane et sensiblement parallèle à l'axe 6 de rotation. Ainsi le patin 4 comprimé aura une bonne efficacité pour éjecter la poignée 1 lors de l'extraction car l'effort exercé par le patin 4 lors de la détente du patin 4 sera colinéaire au mouvement de la poignée 1 lors du début de l'éjection de la poignée 1. La surface 3 d'appui, en présence d'une contrainte importante de faible encombrement, aura une taille réduite. La taille du patin en matériau élastique 4 peut alors lors de la compression s'étendre et déborder au-delà de la surface 3 d'appui. Des efforts particuliers de cisaillement peuvent alors s'exercer sur certains types de patins en matériau élastique 4.

Le patin 4 est avantageusement substantiellement parallélépipédique, c'est-à-dire qu'il est composé d'un corps parallélépipédique qui peut contenir des lacunes et sur lequel peuvent se loger des excroissances. Le patin 4 offre, par rapport à d'autres types de pièces élastiques du type ressort et pour un encombrement donné, une éjection plus efficace de la poignée 1 lors de l'extraction, dans la mesure où la force que peut fournir le patin 4 lors de sa détente est supérieure à la force que peut fournir une pièce élastique de type ressort.

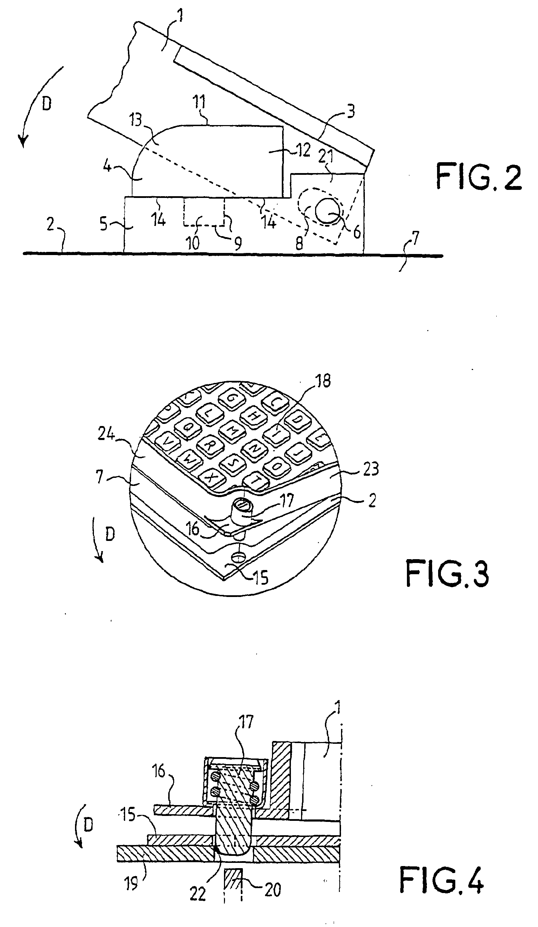

La figure 2 représente schématiquement une vue de profil d'un détail de la figure 1. La poignée 1 comporte un trou 8 oblong au travers duquel passe l'axe 6 de rotation. Le patin 4 présente sur le corps parallélépipédique du patin 4 une excroissance 10 qui est fixée par collage dans un lamage 9 que comporte le bossage 5. Une autre forme que cylindrique pour le lamage 9 peut être envisagée. Le patin 4 présente un côté 11 plus proche de la surface 3 d'appui et à ce niveau le patin 4 présente un angle éloigné 13 de l'axe de rotation ainsi qu'un angle proche 12 de l'axe de rotation. L'angle éloigné 13 est de préférence arrondi, ce qui correspond à une lacune sur le corps parallélépipédique du patin 4. Le corps parallélépipédique du patin 4 est avantageusement fixé par collage sur la surface 14 du bossage 5.

De préférence, le bossage 5 comporte un lamage 9 dans lequel vient se loger une excroissance 10 du patin 4, afin de diminuer pour le patin 4 les risques de chassage hors du bossage 5 lorsque la poignée 1 est rabattue sur la surface 2 du support 7. La solidarité entre le bossage 5 du support 7 et le patin 4 en est améliorée.

La forme du patin 4 est de préférence structurée de manière à ce que du côté 11 du patin 4 qui est le plus proche de la surface 3 d'appui, il y ait moins de matière au niveau de l'angle éloigné 13 de l'axe 6 de rotation qu'au niveau de l'angle proche 12 de l'axe 6 de rotation. Ainsi, lorsque la poignée 1 est rabattue sur la surface 2 de support 7, est évitée la formation d'une lèvre proéminente qui pourrait être cisaillée par la surface 3 d'appui surtout si la surface 3 d'appui est, pour des raisons de faible contrainte d'encombrement, de petite taille. Une telle forme de patin 4 permet d'améliorer conjointement l'effort fourni par la détente du patin 4 lors de l'éjection de la poignée 1 et la déformée du patin 4 lors de sa compression lorsque la poignée 1 est rabattue sur la surface 2 du support 7. Dans une première forme de réalisation préférentielle du patin 4, l'angle éloigné 13 de l'axe 6 de rotation est arrondi, comme sur la figure 2. Dans une deuxième forme de réalisation préférentielle du patin 4, l'angle éloigné 13 de l'axe 6 de rotation est biseauté, l'arrondi de la première forme étant remplacé par un ou plusieurs plans inclinés.

Le patin 4 est réalisé en matériau élastique. Le matériau élastique est à la fois suffisamment mou pour permettre la compression du patin 4 lorsque la poignée 1 est rabattue sur la surface 2 de support 7 lors de l'installation et suffisamment dur pour réussir à éjecter la poignée 1 lors de l'extraction malgré un éventuel coincement de la poignée 1 dans sa position rabattue. Le matériau élastique présente pour cela de préférence une dureté d'environ 60 shores.

Le matériau élastique présente également préférentiellement une bonne fiabilité dans un environnement très agressif. Dans le cas préférentiel de la console d'aéronef, les agressions dont le patin 4 peut être le siège sont nombreuses. Ce sont par exemple des agressions chimiques, comme une boisson renversée sur la console par le pilote, ou bien des poussières ou du sable se glissant dans la console, ou bien encore des moisissures ou des champignons se développant au niveau de la console. Le matériau élastique est avantageusement une résine de silicone, par exemple du type RTV147. Le patin 4 est avantageusement fixé sur la surface 14 du bossage 5 par collage. Le collage utilise préférentiellement une colle silicone, par exemple du type RTV581.

L'équipement comporte préférentiellement des verrous de fixation de l'équipement et de la poignée 1, afin de stabiliser la position relative de l'équipement et du système après l'installation de l'équipement en maintenant la poignée 1 en position rabattue malgré la force contraire de détente du patin en matériau élastique 4 qui est alors comprimé.

La figure 3 représente schématiquement une vue en perspective d'un mode de réalisation préférentiel d'une autre partie de l'équipement selon l'invention. La surface 2 du support 7 est un plan de pose 15 situé sous la partie centrale 18 de l'équipement qui ici est représenté sous la forme d'un clavier comportant des touches. Le support 7 entoure cette partie centrale 18, laquelle est par exemple sensiblement rectangulaire. La poignée 1 vient entourer le support 7 lorsque la poignée 1 est rabattue sur la surface 2 du support 7, c'est-à-dire sur le plan de pose 15, son mouvement suivant la flèche D. Un des verrous, le verrou 17, est intégré à la poignée 1, le verrou 17 étant ici représenté sous la forme d'un rivet. Le verrou 17 est avantageusement situé au niveau de la jonction entre la branche et la barre centrale du U que constitue la poignée 1. La poignée 1 comporte un plan de soutien 16 parallèle à l'axe 6 de rotation.

Préférentiellement, au moins un verrou 17 de fixation de l'équipement est intégré dans la poignée 1 de manière à verrouiller simultanément la poignée 1 et l'équipement, ce qui empêche la vibration éventuelle de la poignée 1 lorsque l'équipement est installé dans un système lui-même amené à subir des vibrations. Dans le cas préférentiel de la console d'un aéronef, la poignée 1 évite alors de produire un bruit de cliquetis désagréable pour le pilote.

Le verrou 17 intégré dans la poignée 1 est avantageusement porté par un plan de soutien 16 parallèle à l'axe 6 de rotation. De préférence, le verrou 17 est un rivet et la surface 2 de support 7 est un plan de pose 15 percé au droit de l'axe du rivet 17. Ainsi, le plan de pose 15 est bloqué par pincement entre le plan de soutien 16 et la structure du système sur lequel l'équipement est installé, cette structure étant un rail 19 de verrouillage sur la figure 4.

Le verrou 17 intégré dans la poignée 1 est situé de préférence suffisamment loin de l'axe 6 de rotation pour permettre l'éjection de la poignée 1 lorsque la poignée 1 repose sur la surface 2 du support 7 et lorsque la poignée 1 est déverrouillée. Idéalement, le verrou 17 est situé à la jonction entre la branche 23 et la barre centrale 24 du U comme sur la figure 3. Plus le verrou 17 est éloigné de l'axe 6 de rotation et donc du patin 4 qui est quant à lui préférentiellement situé près de l'axe 6 de rotation, moindre est l'effort à fournir par le patin en matériau élastique 4 pour l'éjection de la poignée 1 et donc moindre est la contrainte sur l'élasticité du patin en matériau élastique 4.

La figure 4 représente schématiquement une vue en coupe d'un détail de la figure 3. Le verrou 17 est ici avantageusement un rivet de type DZUS. Lorsque la poignée 1 est rabattue vers le plan de pose 15 lors de l'installation, le rivet DZUS 17 qui comporte une fente centrale à filetage hélicoïdal est vissé autour d'un élément filiforme 20. Un rail 19 de verrouillage est solidaire de la structure du système sur lequel l'équipement est installé, le rail 19 est par exemple solidaire du bâti d'une console d'aéronef . Le vissage du rivet DZUS 17 sur l'élément filiforme 20 assure le verrouillage simultané de la poignée 1 et de l'équipement par l'intermédiaire du plan de soutien 16, du plan de pose 15 et du rail 19 de verrouillage. Un des efforts que peut devoir vaincre la force de détente du patin en matériau élastique 4 comprimé est un accrochage restant au niveau de la zone d'accrochage 22 entre le rivet DZUS 17 et le rail 19 de verrouillage.

L'invention est préférentiellement appliquée aux équipements suspendus de console d'aéronef, généralement de forme rectangulaire, qui sont avantageusement verrouillés sur la console par six rivets qui peuvent être des rivets DZUS. Quatre rivets peuvent alors être placés aux angles de l'équipement, dont les deux rivets intégrés à la poignée 1. Deux autres rivets peuvent être placés au milieu des grands côtés de la forme rectangulaire.

## Revendications

1. Equipement pour console d'aéronef comportant un support (7) et une poignée (1) pivotante assemblés par au moins un axe (6) de rotation, la poignée comportant au moins une surface (3) d'appui venant comprimer des moyens d'éjection en matériau élastique dans une position rabattue, la poignée (1) reposant alors sur au moins une surface (2) du support (7),
des verrous pour fixer (17) l'équipement sur la console et maintenir la poignée en position rabattue,
**caractérisé en ce que**
les moyens d'éjection comprennent au moins un patin en matériau élastique (4) de forme substantiellement parallelépipedique, ledit patin étant disposé près de l'axe de rotation de manière a être comprimé, en position rabattue, par sa face (11) supérieure contre le support (7) au moyen de la surface d'appui (3), la forme du patin étant structurée de manière a ce qu'il y ait moins de matière au niveau de l'angle éloigné de l'axe (6) de rotation correspondant à une lacune sur une arête du corps du patin.

2. Equipement selon la revendication 1, **caractérisé en ce que** le patin en matériau élastique (4) est fixé sur le support (7).

3. Equipement selon l'une quelconque des revendications précédentes, **caractérisé en ce que** la surface (3) d'appui est sensiblement plane et sensiblement parallèle à l'axe (6) de rotation.

4. Equipement selon l'une quelconque des revendications précédentes, **caractérisé en ce que** le support (7) comporte un bossage (5) qui comporte l'axe (6) de rotation et le patin en matériau élastique (4).

5. Equipement selon la revendication 4, **caractérisé en ce que** le bossage (5) comporte un lamage (9) dans lequel vient se loger une excroissance (10) du patin (4).

6. Equipement selon l'une quelconque des revendications précédentes, **caractérisé en ce que** le trou (8) de passage dans la poignée (1) traversé par l'axe (6) de rotation est oblong.

7. Equipement selon l'une quelconque des revendications précédentes, **caractérisé en ce que** le matériau élastique est une résine de silicone.

8. Equipement selon l'une quelconque des revendications précédentes, **caractérisé en ce que** le matériau élastique présente une dureté d'environ 60 shores.

9. Equipement selon l'une quelconque des revendications précédentes, **caractérisé en ce que** le patin (4) est fixé à l'équipement par collage.

10. Equipement selon la revendication 1, **caractérisé en ce que** l'angle éloigné (13) de l'axe (6) de rotation est arrondi.

11. Equipement selon la revendication 1, **caractérisé en ce que** l'angle éloigné (13) de l'axe (6) de rotation est biseauté.

12. Equipement selon la revendication 1 **caractérisé en ce qu'**au moins un des verrous (17) est intégré dans la poignée (1) de manière à verrouiller simultanément la poignée (1) et l'équipement.

13. Equipement selon la revendication 12, **caractérisé en ce que** le verrou (17) intégré dans la poignée (1) est situé suffisamment loin de l'axe (6) de rotation pour permettre l'éjection de la poignée (1) lorsque la poignée (1) repose sur la surface (2) du support (7) et lorsque la poignée (1) est déverrouillée.

14. Equipement selon l'une quelconque des revendications 12 à 13, **caractérisé en ce que** le verrou (17) intégré dans la poignée (1) est porté par un plan de soutien (16) parallèle à l'axe (6) de rotation.

15. Equipement selon l'une quelconque des revendications 12 à 14, **caractérisé en ce que** le verrou (17) est un rivet et **en ce que** la surface (2) de support (7) est un plan de pose (15) percé au droit de l'axe du rivet (17).

16. Equipement selon l'une quelconque des revendications précédentes, **caractérisé en ce que** la poignée (1) a une forme en U, les branches (23) du U étant reliées à la barre centrale (24) du U par des angles sensiblement droits.

17. Equipement selon la revendication 16, **caractérisé en ce que** l'équipement comporte un patin en matériau élastique (4) au niveau de chacune des branches (23) du U, un axe (6) de rotation étant situé au niveau de chaque extrémité du U.

18. Equipement selon l'une quelconque des revendications précédentes, **caractérisé en ce que** l'équipement est un équipement suspendu de console d'aéronef.

## Patentansprüche

1. Einrichtung für ein Luftfahrzeug-Steuerpult, mit einem Träger (7) und mit einem schwenkbaren Griff (1), die über mindestens eine Drehachse (6) zusammengebaut sind, wobei der Griff mindestens eine Auflagefläche (3) aufweist, die in einer heruntergeklappten Position Auswerfmittel aus elastischem Material zusammendrückt, wobei der Griff (1) dann auf mindestens einer Fläche (2) des Trägers (7) ruht, mit Riegeln (17), um die Einrichtung auf dem Steuerpult zu befestigen und den Griff in der heruntergeklappten Position zu halten,
**dadurch gekennzeichnet, dass** die Auswerfmittel mindestens einen Unterlageklotz (4) aus elastischem Material von im Wesentlichen parallelepipedischer Form aufweisen, wobei der Unterlageklotz nahe der Drehachse angeordnet ist, um in der heruntergeklappten Position mit seiner Oberfläche (11) über die Auflagefläche (3) gegen den Träger (7) zusammengedrückt zu werden, wobei die Form des Unterlageklotzes so strukturiert ist, dass in Höhe der von der Drehachse (6) entfernten Ecke weniger Material vorhanden ist, was einer Lücke auf einer Kante des Körpers des Unterlageklotzes entspricht.

2. Einrichtung nach Anspruch 1, **dadurch gekennzeichnet, dass** der Unterlageklotz (4) aus elastischem Material am Träger (7) befestigt ist.

3. Einrichtung nach einem der vorhergehenden Ansprüche, **dadurch gekennzeichnet, dass** die Auflagefläche (3) im Wesentlichen eben und im Wesentlichen parallel zur Drehachse (6) ist.

4. Einrichtung nach einem der vorhergehenden Ansprüche, **dadurch gekennzeichnet, dass** der Träger (7) einen Vorsprung (5) aufweist, der die Drehachse (6) und den Unterlageklotz (4) aus elastischem Material enthält.

5. Einrichtung nach Anspruch 4, **dadurch gekennzeichnet, dass** der Vorsprung (5) eine Absenkung (9) aufweist, in die sich eine Ausstülpung (10) des Unterlageklotzes (4) einfügt.

6. Einrichtung nach einem der vorhergehenden Ansprüche, **dadurch gekennzeichnet, dass** das Durchgangsloch (8) im Griff (1), das von der Drehachse (6) durchquert wird, länglich ist.

7. Einrichtung nach einem der vorhergehenden Ansprüche, **dadurch gekennzeichnet, dass** das elastische Material ein Siliconharz ist.

8. Einrichtung nach einem der vorhergehenden Ansprüche, **dadurch gekennzeichnet, dass** das elastische Material eine Härte von etwa 60 Shore aufweist.

9. Einrichtung nach einem der vorhergehenden Ansprüche, **dadurch gekennzeichnet, dass** der Unterlageklotz (4) durch Kleben an der Einrichtung befestigt wird.

10. Einrichtung nach Anspruch 1, **dadurch gekennzeichnet, dass** die von der Drehachse (6) entfernte Ecke (13) abgerundet ist.

11. Einrichtung nach Anspruch 1, **dadurch gekennzeichnet, dass** die von der Drehachse (6) entfernte Ecke (13) abgeschrägt ist.

12. Einrichtung nach Anspruch 1, **dadurch gekennzeichnet, dass** mindestens einer der Riegel (17) in den Griff (1) integriert ist, um gleichzeitig den Griff (1) und die Einrichtung zu verriegeln.

13. Einrichtung nach Anspruch 12, **dadurch gekennzeichnet, dass** der in den Griff (1) integrierte Riegel (17) weit genug von der Drehachse (6) entfernt ist, um den Auswurf des Griffs (1) zu erlauben, wenn der Griff (1) auf der Fläche (2) des Trägers (7) aufliegt und wenn der Griff (1) entriegelt ist.

14. Einrichtung nach einem der Ansprüche 12 bis 13, **dadurch gekennzeichnet, dass** der in den Griff (1) integrierte Riegel (17) von einer Stützebene (16) parallel zur Drehachse (6) getragen wird.

15. Einrichtung nach einem der Ansprüche 12 bis 14, **dadurch gekennzeichnet, dass** der Riegel (17) ein Niet ist, und dass die Fläche (2) des Trägers (7) eine Aufbauebene (15) ist, die gerade vor der Achse des Niets (17) durchbohrt ist.

16. Einrichtung nach einem der vorhergehenden Ansprüche, **dadurch gekennzeichnet, dass** der Griff (1) die Form eines U hat, wobei die Schenkel (23) des U mit der zentralen Stange (24) des U über im Wesentlichen rechte Winkel verbunden sind.

17. Einrichtung nach Anspruch 16, **dadurch gekennzeichnet, dass** sie einen Unterlageklotz (4) aus elastischem Material in Höhe jedes Schenkels (23) des U aufweist, wobei eine Drehachse (6) sich in Höhe jedes Endes des U befindet.

18. Einrichtung nach einem der vorhergehenden Ansprüche, **dadurch gekennzeichnet, dass** sie eine aufgehängte Einrichtung eines Luftfahrzeug-Steuerpults ist.

## Claims

1. Equipment for an aircraft console comprising a support (7) and a pivoting handle (1) which are assembled by at least one pivot pin (6), the handle comprising at least one bearing surface (3) and in a folded-down position compressing ejection means made of an elastic material, the handle (1) then resting on at least one surface (2) of the support, catches (17) for securing the equipment to the console and for keeping the handle in the folded-down position, **characterized in that** the ejection means comprise at least one pad of elastic material (4), of more or less parallelepipidal shape, the said pad being arranged near the pivot pin in such a way as to be compressed, in the folded-down position, via its upper face (11) against the support (7) by means of the bearing surface (3), the shape of the pad being structured so that there is less material at the corner furthest from the pivot pin (6) corresponding to a void along one edge of the body of the pad.

2. Equipment according to Claim 1, **characterized in that** the pad of elastic material (4) is fixed to the support (7).

3. Equipment according to either one of the preceding claims, **characterized in that** the bearing surface (3) is more or less flat and more or less parallel to the pivot pin (6).

4. Equipment according to any one of the preceding claims, **characterized in that** the support (7) comprises a boss (5) which comprises the pivot pin (6) and the pad of elastic material (4).

5. Equipment according to Claim 4, **characterized in that** the boss (5) comprises a counterbore (9) in which a protrusion (10) of the pad (4) is housed.

6. Equipment according to any one of the preceding claims, **characterized in that** the passage hole (8) in the handle (1) through which the pivot pin (6) passes is oblong.

7. Equipment according to any one of the preceding claims, **characterized in that** the elastic material is a silicone resin.

8. Equipment according to any one of the preceding claims, **characterized in that** the elastic material has a Shore hardness of about 60.

9. Equipment according to any one of the preceding claims, **characterized in that** the pad (4) is fixed to the equipment by adhesive bonding.

10. Equipment according to Claim 1, **characterized in that** the corner (13) furthest from the pivot pin (6) is rounded.

11. Equipment according to Claim 1, **characterized in that** the corner (13) furthest from the pivot pin (6) is chamfered.

12. Equipment according to claim 1, **characterized in that** at least one of the catches (17) is built into the handle (1) so as simultaneously to lock the handle (1) and the equipment.

13. Equipment according to Claim 12, **characterized in that** the catch (17) built into the handle (1) is situated far enough away from the pivot pin (6) to allow the handle (1) to be ejected when the handle (1) is resting on the surface (2) of the support (7) and when the handle (1) is unlocked.

14. Equipment according to either one of Claims 12 and 13, **characterized in that** the catch (17) built into the handle (1) is borne by a support plane (16) parallel to the pivot pin (6).

15. Equipment according to any one of Claims 12 to 14, **characterized in that** the catch (17) is a fastener and **in that** the surface (2) of the support (7) is a setting-down plane (15) pierced in line with the axis of the fastener (17).

16. Equipment according to any one of the preceding claims, **characterized in that** the handle (1) is U-shaped, the branches (23) of the U being connected to the central bar (24) of the U by angles which are more or less right angles.

17. Equipment according to Claim 16, **characterized in that** the equipment comprises a pad of elastic material (4) on each of the branches (23) of the U, a pivot pin (6) being situated at each end of the U.

18. The equipment according to any one of the preceding claims, **characterized in that** the equipment is an aircraft console suspended equipment.
